# EUROPÄISCHE PATENTSCHRIFT

(11) **EP 1 657 555 B1**
(45) Veröffentlichungstag und Bekanntmachung des Hinweises auf die Patenterteilung: **20.06.2007**
(21) Anmeldenummer: 05023935.9
(22) Anmeldetag: 03.11.2005
(51) Int. Cl.: G01R 11/04

(54) **Plattform zum Aufstecken eines Stromzählers**
Support platform for coupling an electricity energy meter
Support pour connecter un compteur électrique

(30) Priorität: 10.11.2004 DE 102004054175
(43) Veröffentlichungstag der Anmeldung: 17.05.2006
(73) Patentinhaber: ABB PATENT GmbH, 68526 Ladenburg (DE)
(72) Erfinder: Eppe, Klaus-Peter Dipl.-Ing, 69429 Waldbrunn (DE); Wieland, Ralf Dipl.-Ing (FH), 69429 Waldbrunn (DE)
(74) Vertreter: Miller, Toivo

(56) Entgegenhaltungen:
- EP-A- 1 462 808
- DE-U1-4202004 001 83
- DE-U1-7202004 006 07

## Beschreibung

Die Erfindung betrifft eine Plattform zum Aufstecken eines Stromzählers, gemäß dem Oberbegriff des Anspruches 1.

Es gibt derzeit Bestrebungen, die mechanischen Stromzähler für Haushalte durch elektronische Stromzähler zu ersetzen. Diese elektronischen Haushaltszähler (kurz auch eHZ genannt) besitzen an ihrer Befestigungsseite nach unten herausragende Kontaktstifte, die ins Innere eines Adapters oder einer Zählertragplatte eingesteckt und dort mit geeigneten Kontakteinrichtungen in elektrisch leitende Verbindung gebracht werden.

Damit der Austausch eines Stromzählers oder der Neueinbau einfach bewerkstelligt werden kann, ohne dass beim Ausbau bzw. Austausch der Strom zu den Verbrauchern unterbrochen wird, werden Adapter vorgesehen, in denen sich Kontakteinrichtungen befinden; der Stromzähler wird auf den Adapter dergestalt aufgesetzt, dass die Kontaktstifte durch Schlitze ins Innere des Adapters greifen; sodann wird der Stromzähler verschoben, wobei gleichzeitig eine elektrische Verbindung innerhalb des Adapters aufgetrennt wird, so dass der Strom, der bei nicht eingebauten Stromzähler über die Kontakteinrichtungen direkt zu den Verbrauchern fließt, nunmehr über den Stromzähler geführt ist.

Ähnliche Ausführungen können auch bei Zählertragplatten ein einem Zählerschrank vorgesehen sein.

Insoweit wird unter dem Bergriff "Plattform" sowohl ein Adapter zum nachträglichen Einbau in einen Zählerschrank, der ein Zählerkreuz aufweist, als auch eine von vorneherein zum Aufsetzen des eHZ vorbereitete Zählertragplatte im Zählerschrank verstanden.

Die DE 20 2004 006 077 U1 offenbart eine Plattform zum Aufstecken eines Stromzählers mit einer Abdeckplatte, unter welcher Kontakteinrichtungen vorgesehen sind, mit denen an der Befestigungsseite des Stromzählers angeordnete Kontaktstifte in elektrisch leitende Verbindung gelangen, wobei die Abdeckplatte Schlitze zum Durchstecken der Anschlussfahnen aufweist, und wobei zwischen Abdeckplatte und den Kontakteinrichtungen eine mit den Stiften angepassten weiteren Schlitzen versehene Platte angeordnet ist.

Aufgabe der Erfindung ist es, eine Plattform, d. h. Adapter oder Zählertragplatte, herzustellen, wobei im Auslieferungszustand sichergestellt ist, dass innerhalb der Plattform befindliche, unter Spannung stehende Komponenten nicht von außen durch die Schlitze hindurch zugänglich sind, und der Zugang zu im Inneren der Plattform befindlichen Kontakteinrichtung bei nicht aufgesetztem Stromzähler verhindert wird.

Diese Aufgabe wird erfindungsgemäß gelöst durch die Merkmale des Anspruches 1. Danach befindet sich zwischen der Abdeckplatte und den Kontakteinrichtungen eine mit den Stiften angepassten weiteren Schlitzen versehene Platte, die im Auslieferungszustand die Schlitze in der Abdeckplatte überdeckt und zur Vorbereitung der Montage des Stromzählers verschiebbar ist, wobei nach Verschieben der Platte die weiteren Schlitze sich unterhalb der Schlitze in der Abdeckplatte befinden.

Damit sind die Kontakteinrichtungen innerhalb der Plattform im Auslieferungszustand von der Platte abgedeckt, und zur Montage des Stromzählers ist zunächst die Platte mittels eines von außen durch eine Öffnung oder Aussparung in der Abdeckplatte hindurchführbaren Werkzeuges, z. b. eines Schraubendrehers in diejenige Stellung zu verschieben, in der die weiteren Schlitze der Platte sich unterhalb den Schlitzen der Abdeckplatte befinden.

Wenn die Kontakteinrichtungen pro Phase zwei in Abstand angeordnete Kontakttulpen und eine verschiebbare Brücke enthalten, die in einer Stelle die Kontakttulpen miteinander verbindet und in einer zweiten Stellung eine Trennung bewirkt, wobei die Bewegung der Brücken mit der Bewegung des Stromzählers gekuppelt ist, dann sind an der der Kontakteinrichtung zugewandten Seite der Platte erste Vorsprünge angeformt, die mechanisch formschlüssig mit je einer Brücke gekuppelt sind, so dass beim Verschieben der Platte durch den Stromzähler auch die Brücken über die Platte gleichzeitig verschoben werden. Die Platte ist somit ein Kuppelelement zwischen dem Stromzähler und der Brücke.

Zusätzlich können zweite Vorsprünge an der Platte vorgesehen sein, die zwischen die Arme der Kontakttulpen fahren und sie geringfügig aufweiten, bevor die Brücken in die Kontakttulpen einfahren. Dies dient zum erleichterten Betätigen der Brücken.

Weitere vorteilhafte Ausgestaltungen und Verbesserungen der Erfindung sind den weiteren Unteransprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen und weitere Vorteile der Erfindung näher erläutert und beschrieben werden.

Es zeigen:
- Fig. 1: eine Schnittansicht durch eine Plattform, mit einer Schnittlinie parallel zur Verschieberichtung eines Stromzählers, in einer ersten Stellung,
- Fig. 2: die Plattform in einer zweiten Stellung, in der der Stromzähler eingesetzt werden kann, und
- Fig. 3: den Stromzähler gemäß Figuren 1 und 2 in einer dritten Stellung, in der der Strom durch den Stromzähler fließt.

Eine Plattform 10, wie sie hier bei der Erfindung benutzt werden soll, ist aus der DE 20 2004 006 077 U1 bekannt geworden. Diese Plattform 10 besitzt ein napfartiges Gehäuseunterteil 11, welches mit einer Abdeckplatte 12 verschlossen ist, welche Abdeckplatte mittels Rastarmen auf das Gehäuseunterteil 11 aufgesetzt und daran verrastet werden kann. Die Ausgestaltung der Rastarme und die Art und Weise, wie das Gehäuseunterteil mit der Abdeckplatte zu verbinden ist, ergeben sich aus der DE 20 2004 006 077 U1.

Im Gehäuseunterteil 11 befinden sich im Abstand zueinander angeordnete etwa U-förmige Kontakttulpen 13 und 14, die jeweils in nicht näher dargestellter Weise mit Zugangsklemmen am Gehäuse 10 verbunden sind; auch hierzu wird auf die DE 20 2004 006 077 U1 verwiesen.

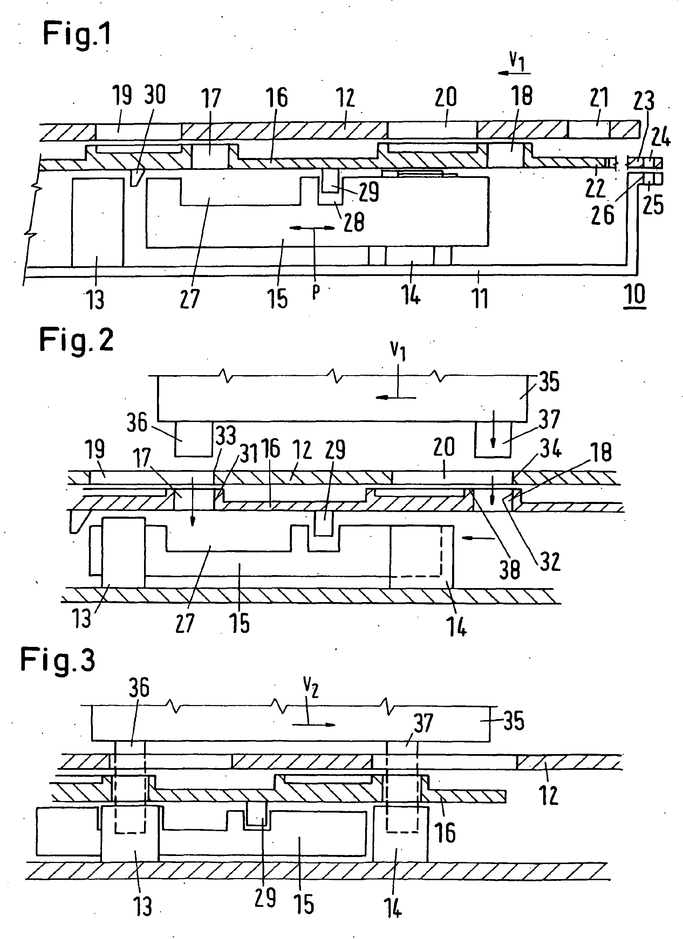

Den Kontakttulpen 13, 14 jeder Phase ist je eine Brücke 15 aus Flachbandmaterial vorzugsweise aus Kupfer zugeordnet, die, wie weiter unten näher erläutert werden soll, in Doppelpfeilrichtung P verschoben wird. In der in Fig. 1 gezeichneten Stellung befindet sich die Brücke 15 zwischen den Schenkeln der Kontakttulpe 14 und ist von der Kontakttulpe 13 getrennt. Die Brücke 15 ist mit ihren Flachseiten senkrecht zum Boden und damit etwa parallel zu den Schenkeln der Kontakttulpe 13, 14 angeordnet, welche ebenfalls etwa senkrecht zum Boden des Gehäuseunterteils 11 ausgerichtet sind.

Der die Schenkel verbindende Steg der Kontakttulpen 13, 14 verläuft parallel zum Boden. Die Kontakttulpen 13, 14 jeder Phase sind über Leiter (nicht dargestellt) mit Zu- und Abgangsklemmen verbunden.

Zwischen den Kontakttulpen 13 und 14 und der Brücke 15 und der Abdeckplatte 12 befindet sich eine Platte 16, die jeweils ein Schlitzpaar pro Phase mit Schlitzen 17 und 18 aufweist, welche einen Abstand voneinander einnehmen, gemessen in der Verschieberichtung P der Brücke 15, der dem Abstand der Kontakttulpen 13, 14, ebenfalls gemessen in der Verschieberichtung, entspricht.

Oberhalb der Kontakttulpen 13 und 14 befinden sich in der Abdeckplatte 12 weitere Schlitze 19, 20, deren Länge dem Verschiebeweg P der Brücke 15 entspricht, siehe auch weiter unten. Weiterhin befindet sich in der Abdeckplatte 12 eine Öffnung 21 und unter der Öffnung 21 in der Platte 16 ein Öffnungsschlitz 22. An der Platte 16 befindet sich weiterhin eine ein Durchsteckloch 24 aufweisende Zunge 23, welche im Auslieferungszustand an der Plattform 10 herausragt, wobei das Durchsteckloch 24 mit einem Durchsteckloch 25 an einer Leiste 26 am Gehäuseunterteil 11 fluchtet, so dass durch die beiden Durchstecklöcher 24 und 25 ein Plombierungsdraht hindurchgeführt werden kann.

Wie aus Fig. 1 hervorgeht, besitzt die Brücke auf der der Platte 16 bzw. der Abdeckplatte 12 zugewandten Längskante zwei Aussparungen 27 und 28, von denen die erste Aussparung 27, in Verschieberichtung der Brücke 15 gemessen, länger ist als die zweite Aussparung 28. Der Grund hierfür wird weiter unten näher erläutert. Auf der der Kontakteinrichtung zugewandten Seite besitzt die Platte einen Vorsprung 29, welcher im montierten Zustand in die zweite Aussparung 28 eingreift und glatt hinein paßt; darüber hinaus ist ein weiterer Vorsprung 30 vorgesehen, der sich außerhalb der Brücke 15 befindet und der beim Verschieben der Platte 16 zwischen die Arme der Kontakttulpen 13 eingreift und diese geringfügig aufweitet, so dass das Einschieben der Brücke 15 in die Kontakttulpe 13 erleichtert wird.

Die Fig. 1 zeigt nun die Anordnung in der Anlieferungsstellung. Hierbei befindet sich die Brücke 15 nur zwischen den Schenkeln der Kontakttulpe 14 und ist von der Kontakttulpe 13 getrennt. Die Schlitze 17 und 18 befinden sich außerhalb der Schlitze 19 und 20 unterhalb der Platte 12 und werden von dieser gegen Zugriff von außen abgedeckt.

Wenn die Plattform gemäß Fig. 1 in die montagebereite Stellung, in der ein Stromzähler 35 montiert werden kann, verbracht werden soll, dann werden mittels eines Werkzeuges, z.B. eines Schraubendrehers welches durch die Öffnung 21 in den Öffnungsschlitz 22 eingeführt werden kann, mit manueller Kraft die Platte 16 und die Brücke 15 (ebenso die Brücken der anderen Phasen) verschoben, bis die Schlitze 17 und 18 sich unterhalb der Schlitze 19 und 20 befinden; in diesem Falle steht die Brücke 15 sowohl mit der Kontakttulpe 13 als auch mit der Kontakttulpe 14 in elektrisch leitender Verbindung. Die Brücke 15 ist bei der Verschiebung der Platte 16 mittels des in die Aussparung 28 eingreifenden Vorsprunges 29 in Pfeilrichtung V₁ verschoben worden; der Verschiebeweg ist durch die Länge der Öffnung 21, gemessen in Verschieberichtung, definiert und so, dass die der Öffnung 21 benachbarte Endkanten 31 und 32 der Schlitze 17 und 18 sich an den ebenso der Öffnung 21 zugewandten Endkanten 33, 34 befinden und etwa damit fluchten. Damit kann der elektrische Stromzähler 35 mit seinen Anschlussfahnen oder -stiften 36 und 37 zunächst durch die Schlitze 19 und 20 und dann durch die Schlitze 17 und 18 hindurch, die Platte 12 durchgreifend, gesteckt werden. Dadurch, dass die Aussparung 27 eine entsprechend bemessene Länge besitzt, gelangt der Anschlussstift 16 des Stromzählers nicht in Berührung mit der Brücke 15; darüber hinaus befindet sich der Anschlussstift 37 auch außerhalb der Tulpe 14.

Wenn nun nach Einschieben der Anschluss- oder Kontaktstifte 36 und 37 durch die Schlitze 19, 20; 17, 18 der Stromzähler 35 in Pfeilrichtung V₁ verschoben wird, dann nehmen die Kontaktstifte 36 und 37 die Platte 12 mit und über den Vorsprung 29 wird auch die Brücke 15 in gleiche Richtung mitgenommen, solange, bis sich die Kontaktstifte 36, 37 des Stromzählers 35 in den Kontakttulpen 13, 14 befinden. Bei der Stellung gemäß Fig. 2 fließt der Strom über die Kontaktbrücke 15 und nicht durch den Stromzähler 35 und nach Verschieben in Pfeilrichtung V₁ in die Stellung gemäß Fig. 3 steht die Kontaktbrücke 15 lediglich mit der Kontakttulpe 13 in elektrisch leitender Verbindung, nicht aber mit der Koritakttulpe 14, so dass der Strom in dieser Stellung durch den Stromzähler hindurchfließt.

Dass die Abmessungen der Abstände der Kontakttulpen sowie die Länge der Brücke 15, die Länge der Arme der Kontakttulpen, gemessen in Verschieberichtung der Brücke 15 und darüber hinaus auch die Länge der Kontaktstifte 36 und 37, die als Flachbandsteckfahnen ausgebildet sind, so zu bemessen sind, dass wenigstens für eine Überlappungszeit der Strom sowohl über die Brücke als auch über den Stromzähler fließt, um definitiv eine Unterbrechung des Stromes zu dem Verbraucher hin zu vermeiden, ist selbstverständlich und nicht Gegenstand der vorliegenden Erfindung.

Wenn nun der Stromzähler 35 durch einen anderen Stromzähler ausgetauscht werden soll, dann wird der Stromzähler 35 entgegen der Verschieberichtung V₁ in die Verschieberichtung V₂ verschoben; dadurch nimmt der Stromzähler 35 die Platte 12 und über den Vorsprung 29 auch die Brücke 15 mit, solange, bis die Kontaktstifte 36 und 37 aus den Kontakttulpen 13, 14 herausgleiten; die entsprechende Stellung der Brücke 15 sowie der Platte 12 ist der Fig. 2 zu entnehmen; in dieser Stellung werden die Kontakttulpen 13 und 14 von der Brücke überbrückt, und die Kontaktstifte 36, 37 und damit der Stromzähler 35 können aus der Plattform 10 entnommen und herausgezogen werden. Auch hier ist selbstverständlich eine Überlappung der Kontaktierung von Brücke 15 und Kontaktstiften 36, 37 während der Demontage gegeben, so dass auch bei der Demontage und beim Austausch der Strom sowohl über die Kontaktbrücke als auch über den Stromzähler 35 wenigstens kurzzeitig fließt, um auch hier eine Stromunterbrechung zu den Verbrauchern zu vermeiden.

Die Abmessungen der Schlitze 17, 18 entspricht den Abmessungen der Kontaktstifte 36, 37, sowohl in Verschieberichtung als auch quer zur Verschieberichtung gemessen. In entsprechender Weise ist die Breite der Schlitze, 19, 20 quer zur Verschieberichtung gemessen genauso breit wie die der Schlitze 17, 18 sowie der Dicke der Kontaktfahnen 36, 37, auch hier ebenfalls quer zur Verschieberichtung gemessen. Die Länge der Schlitze 19, 20 ist so bemessen, dass sich die Kontaktfahnen 36, 37 aus der Einsteckstellung in ihre Endstellung bewegen können, in der sie mit den Kontakttulpen 13, 14 in Verbindung gelangt sind.

Dass um die Schlitze 17, 18 Leisten 38 herum angeordnet sind (lediglich die Leiste um den Schlitz 18 ist beziffert), ist eine Notwendigkeit wegen des Berührungsschutzes.

Die erste Aussparung 27 ist so bemessen, dass der Kontaktstift 36 in keinem Fall die Brücke berührt.

Die Ausgestaltung gemäß den Zeichnungen ist für eine Phase beschrieben; natürlich ist die erfindungsgemäße Ausgestaltung auch bei den anderen Phasen verwirklicht.

## Patentansprüche

1. Plattform zum Aufstecken eines Stromzählers (35), mit einer Abdeckplatte (12) unter welcher Kontakteinrichtungen (13, 14; 15) vorgesehen sind, mit denen an der Befestigungsseite des Stromzählers (35) angeordnete Kontaktstifte (36, 37) in elektrisch leitende Verbindung gelangen, wobei die Abdeckplatte (12) Schlitze (19, 20) zum Durchstecken der Anschlussfahnen (36, 37) aufweist, und wobei zwischen der Abdeckplatte (12) und den Kontakteinrichtungen (13 bis 15) eine mit den Stiften angepassten weiteren Schlitzen (17, 18) versehene Platte (16) angeordnet ist, **dadurch gekennzeichnet, dass** die Platte (16) im Auslieferungszustand die Schlitze (19, 20) überdeckt und zur Vorbereitung der Montage des Stromzählers (35) verschiebbar ist, wobei nach Verschieben der Platte (16) die weiteren Schlitze (17,18) sich unterhalb der Schlitze (19, 20) der Abdeckplatte befinden.

2. Plattform nach Anspruch 1, **dadurch gekennzeichnet, dass** das Verschieben der Platte (16) mittels eines durch eine Aussparung (21) in der Abdeckplatte (12) in einen Öffnungsschlitz (22) in der Platte (16) einführbaren Werkzeuges erfolgt.

3. Plattform nach Anspruch 1 oder 2, **dadurch gekennzeichnet, dass** die Platte (16) eine Zunge (23) aufweist, der aus der Plattform herausragt und mit dieser plombierbar ist.

4. Plattform nach einem der vorherigen Ansprüche, mit Kontakteinrichtungen, die je Phase zwei in Abstand angeordnete Kontakttulpen (13, 14) und eine verschiebbare Brücke (15) enthalten, die in einer Stellung die Kontakttulpen verbindet und in einer zweiten Stellung die Kontakttulpen (13, 14) voneinander trennt, und die mit der Bewegung des Stormzählers (35) gekuppelt ist und **dadurch** auch bewegt wird, **dadurch gekennzeichnet, dass** an der der Kontakteinrichtung zugewandten Seite der Platte (16) erste Vorsprünge (29) angeformt sind, die mechanisch formschlüssig mit je einer Brücke (15) gekuppelt sind, so dass beim Verschieben der Platte (16) durch den Stromzähler auch die Brücken (15) gleichsinnig verschoben werden.

5. Plattform nach Anspruch 4, **dadurch gekennzeichnet, dass** an der Platte zweite Vorsprünge (13) an der Platte (16) vorgesehen sind, die beim Verschieben zwischen die Arme einer Kontakttulpe (13) fahren und sie geringfügig aufweiten, bevor die Brücke (15) in die Kontakttulpen (13) einfahren.

## Claims

1. A platform for inserting an electricity meter (35), comprising a cover plate (12) under which contact devices (13, 14; 15) are provided, with which contact pins (36, 37) arranged on the fastening side of the electricity meter (35) come into electrically conductive connection, with the cover plate (12) comprising slits (19, 20) for pushing through the terminal lugs (36, 37) and with a plate (16) being arranged between the cover plate (12) and the contact devices (13 to 15), which plate is provided with further slits (17, 18) adjusted to the pins, **characterized in that** the plate (16) covers the slits (19, 20) in the delivery state and is displaceable for preparation of the mounting of the electricity meter (35), with the further slits (17, 18) being situated beneath the slits (19,20) of the cover plate after the displacement of the plate (16).

2. A platform according to claim 1, **characterized in that** the displacement of the plate (16) occurs by means of a tool that can be inserted through a cavity (21) in the cover plate (12) into an opening slit (22) in the plate (16).

3. A platform according to claim 1 or 2, **characterized in that** the plate (16) comprises a tongue (23) which protrudes from the platform and which can be sealed with the same.

4. A platform according to one of the preceding claims, comprising contact devices which contain per phase two contact tulips (13, 14) arranged at a distance and a displaceable bridge (15) which connects the contact tulips in one position and separates the tulips (13, 14) from each other in a second position and which is coupled with the movement of the electricity meter (35) and is thus also moved, **characterized in that** first projections (29) are formed on the side of the plate (16) facing the contact device, which projections are coupled mechanically in an interlocking manner with a bridge (15) each, so that on displacement of the plate (16) by the electricity meter the bridges (15) are also displaced in the same direction.

5. A platform according to claim 4, **characterized in that** second projections (13) are provided on the plate (16) which on displacement move between the arms of a contact tulip (13) and widens the same slightly before the bridge (15) moves into the contact tulips (13).

## Revendications

1. Plateforme pour enficher un compteur électrique (35) comportant une plaque de couverture (12) en dessous de laquelle sont prévus les dispositifs de contact (13, 14 ; 15) avec lesquels des broches de contact (36, 37) disposées sur la face de fixation du compteur électrique (35) viennent en liaison électrique, la plaque de couverture (12) présentant des fentes (19, 20) pour le passage des broches (36, 37) avec, entre la plaque de couverture (12) et les dispositifs de contact (13 à 15) une autre plaque (16) percée d'autres fentes (17) adaptée aux broches (36, 37), **caractérisée en ce que** la plaque (16), à l'état de livraison, recouvre les fentes (19, 20) et peut coulisser pour préparer le montage du compteur électrique (35), après quoi les autres fentes (17, 18) se trouvent en dessous des fentes (19, 20) de la plaque de couverture (12).

2. Plateforme selon la revendication 1, **caractérisée en ce que** le coulissement de la plaque (16) est réalisé au moyen d'un outil qui peut être introduit à travers un évidement (21) de la plaque de couverture (12), dans une fente d'ouverture (22) prévue dans la plaque (16).

3. Plateforme selon la revendication 1 ou 2, **caractérisée en ce que** la plaque (16) présente une languette (23) qui fait saillie sur la plateforme et peut être reliée à celle-ci par une liaison plombée.

4. Plateforme selon une des revendications précédentes, comportant des dispositifs de contact contenant pour chaque phase deux tulipes de contact (13, 14) espacées l'une de l'autre et un pont (15) coulissable qui, dans une position relie les tulipes de contact, tandis que dans une seconde position il les sépare, le pont étant couplé au mouvement du compteur électrique (35) et se déplaçant ainsi avec lui, **caractérisée en ce que** sur le côté de la plaque (16) en regard du dispositif de contact, sont formées des premières saillies (29) qui sont couplées chacune à un pont (15) avec verrouillage mécanique par combinaison de formes, de sorte que quand la plaque (16) coulisse, également les ponts (15) coulissent dans le même sens par l'intermédiaire du compteur électrique.

5. Plateforme selon la revendication 4, **caractérisée en ce que** sur la plaque (16) sont prévues deux saillies (30) qui se déplacent par coulissement entre les bras d'une tulipe de contact (13) en écartant légèrement ceux-ci avant que les ponts s'engagent dans les tulipes de contact (13).
